(19) Europäisches Patentamt
European Patent Office
Office européen des brevets

(11) Veröffentlichungsnummer: **0 153 683**
**B1**

(12) # EUROPÄISCHE PATENTSCHRIFT

(45) Veröffentlichungstag der Patentschrift: **12.04.89**

(51) Int. Cl.⁴: **H 05 K 3/18**, H 05 K 3/38, C 23 C 18/28

(21) Anmeldenummer: **85101732.7**

(22) Anmeldetag: **16.02.85**

(54) **Verfahren zur Herstellung von Leiterplatten.**

(30) Priorität: **28.02.84 DE 3407114**

(43) Veröffentlichungstag der Anmeldung: **04.09.85 Patentblatt 85/36**

(45) Bekanntmachung des Hinweises auf die Patenterteilung: **12.04.89 Patentblatt 89/15**

(84) Benannte Vertragsstaaten: **BE CH DE FR GB IT LI NL SE**

(56) Entgegenhaltungen:
**EP-A-0 081 129**
**GB-A-1 154 152**
**GB-A-2 066 582**
**US-A-4 097 286**

**METALLOBERFLÄCHE, Band 31, Nr. 11, November 1977, Seiten 497-505, München, DE; G. HERRMANN: "Volladditivtechnik zur Herstellung von Leiterplatten"**

(73) Patentinhaber: **BAYER AG, Konzernverwaltung RP Patentabteilung, D-5090 Leverkusen 1 Bayerwerk (DE)**

(72) Erfinder: **Sirinyan, Kirkor, Dr., Humperdinckstrasse 12, D-5060 Bergisch Gladbach 2 (DE)**
Erfinder: **Wolf, Gerhard Dieter, Dr., Wilhelm-Busch-Strasse 29, D-4047 Dormagen (DE)**
Erfinder: **von Gizycki, Ulrich, Dr., Wiembachallee 24, D-5090 Leverkusen 3 (DE)**
Erfinder: **Merten, Rudolf, Dr., Berta-von-Suttner-Strasse 55, D-5090 Leverkusen (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen.. Er gilt erst als eingelegt, wenn die Einspruchsgebühr entrichtet worden ist (Art. 99(1) Europäisches Patentübereinkommen).



ACTORUM AG

## Beschreibung

Gegenstand der Erfindung ist ein naßchemisches Verfahren zur Herstellung von Leiterplatten nach der Additiv- bzw. Semiadditivmethode.

Es ist allgemein bekannt, daß die Abscheidung von haftfesten Metallauflagen auf den üblichen Isolierbasismaterialien eine aufwendige Vorbehandlung erfordert. So müssen beispielsweise die Basisplatten zunächst mit einer Haftvermittlerschicht versehen und anschließend mit oxidierenden Flüssigkeit, vorzugsweise Chromschwefelsäure, behandelt werden, bevor die so präparierten Platten mit ionischen oder kolloidalen Edelmetallösungen aktiviert, maskiert und in handelsüblichen Metallisierungsbädern metallisiert werden.

Abgesehen von der Vielstufigkeit dieser Methoden weist diese Technik den Nachteil auf, daß eingeschleppte Chromionen die Bäder irreversibel vergiften und daß die erhaltenen Leiterplatten unbefriedigende elektrische Eigenschaften zeigen.

Es ist daher bereits vorgeschlagen worden, die nichtleitenden Oberflächen von Substraten, beispielsweise auch Basisträger von Leiterplatten, ohne oxidative Vorbehandlung mit einer Lösung oder einem Lack einer Edelmetallkomplexverbindung, die gegebenenfalls auch «funktionelle» Gruppen enthalten können, für die anschließende chemische Metallisierung zu aktivieren. (vgl. z.B. EP-A 81129, DE-A 1 696 603 und 2 116 389).

Diese an sich materialschonenden Aktivierungsverfahren konnten sich jedoch bislang in der Praxis der Leiterplattenherstellung nicht durchsetzen, da sie verhältnismäßig große Aktivatormengen benötigen und/oder die in der Elektroindustrie geforderten hohen Abzugsfestigkeiten der Metallauflagen nicht erreichen.

Es wurde nun gefunden, daß man diese Nachteile vermeiden und zu hochwertigen Leiterplatten gelangen kann, wenn man in der Weise verfährt, daß man

a) die Basisplatten mit einem Aktivatorsystem behandelt, das in einem Lösungsmittel Komplexverbindungen der Elemente der I. oder VIII. Nebengruppe des Periodensystems enthält, die mindestens eine haftvermittelnde funktionelle Gruppe aufweisen,

b) nach dem Verdampfen des Lösungsmittels eine Resistauflage aufbringt und diese nach einem Resistmuster partiell belichtet,

c) anschließend die unbelichteten und damit unvernetzten Bereiche der Resistauflage mit einem Lösungsmittel, das gleichzeitig ein Quellmittel für die Oberfläche der Basisplatten ist, herauslöst und

d) die auf diese Weise freigelegten Bereiche – gegebenenfalls nach Überführung in ein Sensibilisierungsbad – in einem üblichen naßchemischen Metallisierungsbad stromlos metallisiert und gegebenenfalls galvanisch verstärkt.

Obwohl die 4 Teilschritte, d.h. Aktivierung, Maskierung, partielle Entfernung der Maske und Metallisierung, an sich bekannt sind, ist es als ausgesprochen überraschend zu bezeichnen, daß auf diesem Wege festhaltende und konturenscharfe Metallauflagen erhalten werden, da erwartet werden konnte, daß beim Herauslösen der nicht ausgehärteten Resistauflage und dem Anquellen der Trägeroberfläche auch der Aktivator zumindest teilweise entfernt wird.

Geeignete Komplexverbindungen in den Aktivatorlösungen sind π-Komplexe von Olefinen, konjugierten Dienen und α,β-ungesättigten Ketonen sowie Chelatkomplexe von Nitril-, Amin-, Carboxyl-, Hydroxyl-, Sulfonsäure- und Sulfonamidgruppenhaltigen Verbindungen, die außer diesen zur Metallkomplexbildung benötigten Gruppen mindestens eine weitere funktionelle Gruppe enthalten, die die Haftfestigkeit des Aktivators auf der Substratoberfläche verbessert.

Dieses kann durch eine chemische Reaktion mit der Substratoberfläche vorzugsweise aber durch Ausbildung von Wasserstoffbrückenbindungen oder durch die Wirkung von der Waalsscher Kräfte erreicht werden.

Besonders geeignet für eine solche chemische Verankerung des Aktivators an der Substratoberfläche sind funktionelle Gruppe wie Carbonsäuregruppen, Carbonsäurehalogenidgruppen, Carbonsäureanhydridgruppen, Carbonestergruppen, Carbonamid- und Carbonimidgruppen, Aldehyd- und Ketongruppen, Ethergruppen, Sulfonamidgruppen, Sulfonsäuregruppen und Sulfonatgruppen, Sulfonsäurehalogenidgruppen, Sulfonsäureestergruppen, halogenhaltige heterocaclische Reste, wie Chlortriazinyl-, -pyrazinyl-, -pyrimidyl- oder -chinoxalinylgruppen, aktivierte Doppelbindungen, wie bei Vinylsulfonsäure- oder Acrylsäurederivaten, Aminogruppen, Hydroxylgruppen, Isocyanatgruppen, Olefingruppen und Acetylengruppen sowie Mercaptogruppen und Epoxidgruppen, ferner höherkettige Alkyl- oder Alkenylreste ab $C_8$, insbesondere Olein-, Linolein-, Stearin- oder Palmitingruppen.

Ganz besonders gut geeignet sind funktionelle Gruppen wie Carbonsäuregruppen, Carbonsäureanhydridgruppen, Amidgruppen, Carbonsäureimidgruppen, Keto-, Aldehyd- und Estergruppen.

Es ist zweckmäßig, die die Adsorption hervorrufenden funktionellen Gruppen auf das jeweilige Substrat abzustimmen. So verbessern z.B. langkettige Alkyl- oder Alkenyl-Gruppen im Aktivatormolekül die Haftfestigkeit auf Substraten aus Polyethylen oder Polypropylen. Zur Metallisierung von Gegenständen auf Polyamid- oder Polyesterbasis sind dagegen Aktivatoren mit beispielsweise zusätzlichen Carbonyl- oder Sulfon-Gruppen besonders günstig.

Bevorzugte Aktivatoren sind organometallische π-Verbindungen der Elemente Pd, Au, Pt, Ag, wie sie z.B. in DE-A 3 148 280 beschrieben sind. Besonders bevorzugt sind die ebenfalls zum Teil bekannten bzw. nach an sich bekannten Verfahren erhältlichen Komplexverbindungen der Elemente der I. oder VIII. Nebengruppe des Periodensystems in den Oxidationsstufen 1–4 (insbesondere einwertiges Palladium) mit ungesättigten Ketonen der Formel

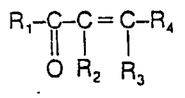

worin

$R_1$ und $R_4$ $C_1$–$C_{20}$-Alkyl, vorzugsweise $C_1$–$C_6$-Alkyl,

$R_2$ und $R_3$ Wasserstoff oder $C_1$–$C_4$-Alkyl, vorzugsweise Methyl bedeuten.

Beispielhaft seien genannt: Mesityloxid, n-Buten-3-on-2, n-Hepten-3-on-2, n-Hexen-3-on-2, n-Decen-4-on-3, 5-Chlor-penten-3-on-2, Ethylvinylketon, 3-Methyl-octen-5-on-4, 3-Methyl-penten-3-on-2, 7-Methoxy-hepten-3-on-2.

Weitere Beispiele für bevorzugte Komplexbildner sind: Butadien, 4-Cyclohexen-1,2-dicarbonsäureanhydrid und 4-Cyclohexen-1,2-dicarbonsäureimid. Besonders bevorzugt sind deren Palladiumkomplexe.

Das erfindungsgemäß neue Verfahren wird zweckmäßigerweise so durchgeführt, daß man Basismaterialien mit den o.a. organometallischen Verbindungen benetzt. Dies kann vornehmlich durch Besprühen mit einer leicht flüchtigen organischen Lösung der genannten Aktivatoren oder durch Tauchen in diese Medien erfolgen. Hierbei soll die Konzentration des Aktivators zwischen 0,01 g und 10 g pro Liter Lösungsmittel betragen. Als Lösemittel kommen vorzugsweise chlorierte Kohlenwasserstoffe wie $HCCl_3$, $CCl_4$, $CH_2Cl_2$, $ClCH{=}CCl_2$, Alkohole wie $C_2H_5OH$, $CH_3OH$ und deren Gemische untereinander in Betracht.

Die so behandelten Basismaterialien werden mit einer rasterförmigen Maske partiell abgedeckt, in einem Lösemittel angequollen, sensibilisiert und dann in einem reduktiven Metallisierungsbad partiell metallisiert.

Zum partiellen Abdecken der Basismaterialien kommt in den meisten Fällen ein «Resistfilm» (Photolacke, Photoresists), und zwar «Negativ-Resists» in Betracht. (Siehe beispielsweise Günther Hermann, «Leiterplatten, Herstellung und Vorbehandlung», S. 98–103 und 125–127.)

Nach dem Belichten werden die unbelichteten Teile mit einem geeigneten Lösungsmittel entfernt. Zur Herstellung von Reliefs für die Elektronik bzw. für die Mikroelektronik können eine Reihe von speziellen Resistsystemen verwendet werden. In diesem Zusammenhang seien die mit Hilfe von UV-Strahlung, Elektronenstrahlung und Laserstrahlung härtbaren Resistsysteme erwähnt (vgl. DE-A 2 007 267, DE-A 2 454 879 und DE-A 2 507 874).

Das Aufbringen der Reliefmaske kann durch Siebdrucken, Beschichten oder Bestempeln erfolgen.

Als Substrate für das erfindungsgemäße Verfahren eignen sich Platten, vorzugsweise mit Normallöchern versehene Platten aus glasfaser- und glasmattenverstärkten Epoxidharzen (s. beispielsweise Kunststoffhandbuch, Prof. R. Vieweg, XI, S. 180–246, Carl Hanser Verlag, München (1971)), fluorhaltigen Polymerisaten (s. beispielsweise o.a. Literaturstelle S. 673–674) wie PTFE (Polytetrafluorethylen), wärmehärtbaren Kunststoffen wie Phenol-Formalin- und/oder Melaminharze (s. beispielsweise Prof. R. Vieweg «Kunststoff-Handbuch» X, S. 19–59 und 63–128), Polypropylen, Polyethylen, ABS- (Acrylnitril-Butadien-Styrol)-Misch- oder Pfropfcopolymerisate und Polykondensate (z.B. Polycarbonate, aromatisch und/oder aliphatische Polyamide, Polyester, aromatische und/oder aliphatische Polyamide bzw. Polyamid-Imide bzw. deren Mischung- oder Cokondensate).

Zum Herauslösen der nicht vernetzten Teile der Resistauflage eignen sich übliche organische Lösungsmittel, in denen das Präpolymere der Lackauflagen gut löslich ist. Dabei werden solche Lösungsmittelsysteme gewählt, die zugleich ein Quellmittel für die Substrate sind.

Zur Behandlung von Substraten auf der Basis von Polyamidkondensaten werden beispielsweise Lösungen eines Gemisches von Halogeniden von Elementen der 1. und/oder 2. Hauptgruppe des Periodensystems mit Salzen aus schwachen anorganischen Basen und starken anorganischen Säuren eingesetzt.

Geeignete Halogenide von Elementen der 1. und 2. Hauptgruppe sind insbesondere die Chloride; bevorzugt sind LiCl, $BeCl_2$, $MgCl_2$ und $CaCl_2$.

Geeignete Salze schwacher Basen und starker Säuren sind Sulfate, Nitrate und vor allem Chloride von Metallen der 3. und 4. Haupt- und Nebengruppe sowie von Nichtedelmetallen der 6.–8. Nebengruppe. Bevorzugt sind $FeCl_2$, $FeCl_3$, $TiCl_3$, $TiCl_4$, $BCl_3$ und insbesondere $AlCl_3$.

Geeignete Quell- und Lösungsmittel sind solche wie sie in üblichen Handbüchern über Polyamide beschrieben sind [vgl. z.B. «Die Polyamide» von Hopff. Müller, Wegner, Springer-Verlag (1954), sowie «Polymer Handbook» von Brandrup et al, New York, Band IV (1975) sowie «Kunststoffhandbuch» von Vieweg/Müller; Band IV (1966)]. Beispielsweise seien genannt: niedrige aliphatische und araliphatische Alkohole, wie z.B. Methanol, Ethanol, Isopropanol, n-Propanol, n-Butanol, Benzylalkohol und Phenylethylalkohol. Besonders bevorzugt ist Methanol. Auch Dimethylsulfoxid und amidgruppenhaltige Lösungsmittel wie Formamid und Dimethylformamid, kommen in Betracht. Selbstverständlich sind auch Mischungen dieser Lösungsmittel einsetzbar.

Gewünschtenfalls können auch übliche Polyamidweichmacher (0,2–10 Gew.-%, bzw. 0,5–5 Gew.-% bezogen auf die gesamte Flüssigkeitsmenge) zugesetzt werden. Beispielhaft seien Benzolsulfonsäuremonoethylamid, p-Toluolsulfonsäureamid, Dioxidiphenylsulfon und Dibenzylalkohol genannt.

Nach der Lösungsmittelbehandlung werden die so erhaltenen «Halbzeuge» von anhaftendem Lösungsmittel befreit.

Das geschieht im allgemeinen durch Verdampfen, gegebenenfalls unter reduziertem Druck. Höher siedende Lösungsmittel werden zweckmäßigerweise durch Extraktion oder Spülen mit niedrigsiedenden Lösungsmitteln entfernt.

Werden Fluorpolymerisate als Substrate eingesetzt, geht man vorzugsweise bei der Durchführung dieser Variante so vor, daß man diese Polymerisate durch Tauchen in einer organischen, vorzugsweise wasserfreien, Lösung wie THF (Tetrahydrofuran), Benzol und Toluol, die zusätzlich eine alkaliorganische Verbindung mit einem einsamen, zur Bildung von einem Carbanion oder Carbkation befähigten Elektronenpaar enthält, behandelt. In diesem Zusammenhang sei auf die Literaturstellen «N.D. Scott et. al.: Am. Soc. 58, 2443 (1936); N.D. Scott: USP 2 181 771; M. Szwarc: Nature 178, 1168 1956; M. Szwarc: Am. Soc. 78, 2656 (1956)» hingewiesen. Wobei Naphthalinnatrium, Naphthalinlithium, Benzollithium, Benzolnatrium, Biphenyl- Triphenyl- und Butyl-lithium bzw. natrium besonders zu bevorzugen sind. Die Konzentration der alkaliorganischen Verbindungen soll 0,01 bis 250, vorzugsweise 2,5–100, besonders bevorzugt 5–75 g pro Liter Lösemittel betragen.

Die so vorbehandelten Halbzeugplatten werden getrocknet und dann mit $H_2O$ oder niederen Alkoholen gewaschen. Anschließend werden sie aktiviert, mit einem handelsüblichen Resist beschichtet und zu einer partiellen Metallisierung auf dem naßchemischen Wege vorbereitet.

Die Halbzeuge, beispielsweise die besonders bevorzugten Fluorpolymere, weisen überraschenderweise eine ausgezeichnete Haftung mit den besagten metallorganischen Aktivatoren, handelsüblichen Resists bzw. Siebdruckauflagen auf und lassen sich auch mit einer partiell sehr gut haftenden Metallauflage versehen.

Die zur Herstellung von erfindungsgemäßen Basismaterialien ebenso bevorzugt einsetzbaren Duroplaste auf der Basis von Phenol-, Epoxid- und Melaminharzen können selbstverständlich mit einem Haftvermittlerlack (s. beispielsweise G. Hermann, Leiterplatten, Herstellung und Vorbereitung, S. 164–168, Eugen G. Lenze Verlag, Saulgau/Württ. (1978)), der eine kautschukelastische Komponente enthält, beschichtet werden. Ebenso können sie nach ihrer Aktivierung zur Erhöhung der Abzugsfestigkeit der im letzten Schritt abgeschiedenen Metallschicht in für die ABS-Polymerisate üblichen Löse- oder Quellmittel [s. beispielsweise «Polymer-Handbook» Brandrup et. al. New York, Band IV (1975)] bzw. in oxidierend wirkenden Medien behandelt werden.

Die Halbzeugbasismaterialien zur Herstellung von Leiterplatten sollen folgende Eigenschaften aufweisen:

1. Sie sollen im aktivierten Zustand an der Luft gegenüber Feuchtigkeit stabil sein.
2. Ihre Aktivatorauflage soll nicht während des Aufbringens bzw. des Entwickelns von Fotoresistauflagen von der Oberfläche entfernbar oder gar desaktivierbar sein.
3. Ihre Aktivatorauflage soll nicht während einer Quell- oder Oxidantieneinwirkung von der Oberfläche entfernt bzw. desaktiviert werden.
4. Ebenso darf die Reliefauflage während des Quell- oder Abbauvorganges von der Materialoberfläche nicht abgeschwemmt werden.
5. Bei der Sensibilisierung bzw. Metallisierung dürfen keine Liganden freiwerden, die die Metallisierung- oder Sensibilisierungsbäder vergiften.

Die Halbzeuge müssen anschließend durch Reduktion sensibilisiert werden. Dazu können bevorzugt die in der Galvanotechnik üblichen Reduktionsmittel, wie Hydrazinhydrat, Formaldehyd, Hypophosphit oder Borane verwendet werden. Natürlich sind auch andere Reduktionsmittel möglich. Bevorzugt wird die Reduktion in wäßriger Lösung durchgeführt. Es sind aber auch andere Lösungsmittel wie Alkohole, Ether, Kohlenwasserstoffe einsetzbar. Selbstverständlich können auch Suspensionen oder Aufschlämmungen der Reduktionsmittel verwendet werden.

Die so sensibilisierten Oberflächen können direkt zur stromlosen Metallisierung eingesetzt werden. Es kann aber auch erforderlich sein, die Oberfläche durch Spülen von den Reduktionsmittelresten zu reinigen.

Eine ganz besonders bevorzugte Ausführungsform des erfindungsgemäßen Verfahrens besteht darin, daß die Reduktion im Metallisierungsbad gleich mit dem Reduktionsmittel der stromlosen Metallisierung durchgeführt wird. Diese Ausführung stellt eine bisher nicht mögliche Vereinfachung der stromlosen Metallisierung dar.

Diese Ausführungsform ist ganz besonders für aminboranhaltigen Nickelbäder oder formalinhaltige Kupferbäder geeignet.

Als in dem erfindungsgemäßen Verfahren einsetzbare Metallisierungsbäder kommen bevorzugt Bäder mit Nickelsalzen, Cobaltsalzen, Kupfersalzen, Gold- und Silbersalzen oder deren Gemische untereinander oder mit Eisensalzen in Betracht. Derartige Metallisierungsbäder sind in der Technik der stromlosen Metallisierung bekannt.

Selbstverständlich können diese auf chemischem Weg abgeschiedenen Metallauflagen in den galvanischen Metallisierungsbädern verkupfert, versilbert, verzinnt und verzinkt werden.

Beispiel 1

Eine 200 × 200 × 1 mm große glasfaserverstärkte Polymerplatte aus Polyamid-6 wird mit 0,5 mm großen Löchern versehen, in einem Bad aus 1 Liter $CH_2Cl_2$ und 1,0 g 4-Cyclohexen-1,2-dicarbonsäureanhydrid-palladium(II)-chlorid im Verlaufe von 5 Minuten bei Raumtemperatur aktiviert und getrocknet. Das so hergestellte aktive Basismaterialhalbzeug wird nach 7 Tagen mit einer handelsüblichen Siebdruckmaske auf der Basis von Styrolbutadiencopolymerisat, welche freie kammförmige Bahnen von etwa 500 µm Breite aufweist, bedeckt und dann in einem Bad, welches aus 1400 ml Methanol, 120 g $CaCl_2$, 2,0 g $AlCl_3$ und 400 ml $H_2O$ dest. besteht, 5 Minuten nachbehandelt. Anschließend wird die Platte in einem Bad, bestehend aus 1200 ml Ethanol, 24 ml $NH_3$-Lösung (25%ig) und 500 ml 2n DMAB (Dimethylaminboran)-Lösung 5 Min. sensibilisiert, gewaschen und dann in einem handelsüblichen Verkupferungsbad auf dem chemischen Wege verkupfert.

Nach etwa einer Minute färben sich die freien Bahnen dunkel und nach 25 Min. wird eine elektrisch leitende Cu-Auflage abgeschieden, die mit galvanischem Kupfer auf 40 µm verstärkt wird.

Man bekommt eine durchkontaktierte, elektrische Leiterbahnplatte mit 500 µm breiten und 40 µm starken Leiterbahnen. Die Metallauflage haftet an der Substratoberfläche so gut, daß sie trotz einer einminütigen Nachbehandlung bei 265 °C in einem handelsüblichen Lötbad nicht von der Polymeroberfläche zu entfernen ist.

Beispiel 2

Eine 200 × 250 × 1 mm große handelsübliche kautschukgepfropfte Polyamid-6-Platte wird mit 0,2 mm großen Löchern versehen, in einem Bad aus 1 Liter $CH_2Cl_2$ und 0,9 g Mesityloxid-palladiumchlorid im Verlaufe von 4 Minuten bei 18 °C aktiviert, getrocknet, mit einem UV-härtbaren Lack auf der Basis von Oligomeren 1.4-Polyisopren (5 Gew.-%ig in Xylol) mit lichtempfindlichem Diazo-Initiator der Fa. AGFA-GEVAERT AG, besprüht und die Lackschicht physikalisch gehärtet. Nach einer Woche wird die aktive Halbzeug-Oberfläche mit einer Fotomaske bedeckt und mit Hilfe von UV-Bestrahlung partiell vernetzt. Der nicht vernetzte Präpolymeranteil wird nach Entfernen der Maske vom Probekörper in Methanol (reinst) entfernt. Anschließend wird das Basismaterial in einem Bad aus 700 ml Methanol, 50 ml n-Butanol, 80 g $CaCl_2$ und 2 g $TiCl_4$ bei Raumtemperatur 8 Minuten nachbehandelt, gemäß Beispiel 1 sensibilisiert, getrocknet und dann in einem handelsüblichen Vernickelungsbad vernickelt. Nach etwa zwei Minuten färben sich die freien Bahnen silbergrau und nach ca. 20 Minuten wird eine elektrisch gut leitende Ni-Auflage abgeschieden, die mit galvanischem Silber auf 40 µm verstärkt wird.

Man bekommt eine durchkontaktierte Leiterplatte mit 30 µm breiten und 40 µm starken Leiterbahnen. Die Abzugsfestigkeit der Metallauflage, gemessen nach DIN 53 494, beträgt ca. 60 N/25 mm und besteht den zweiminütigen Lötbadtest bei 255 °C.

Beispiel 3

Eine 100 × 100 × 1 mm große 40% mineralfaserverstärkte Polymerplatte aus Polyamid-6 wird in einem Bad aus 0,8 g 4-Cyclohexen-1,2-dicarbonsäure-imid-palladium(II)-chlorid und 1 Liter $CH_2Cl_2$ bei 35 °C 3 Minuten aktiviert, getrocknet und dann mit einem UV-härtbaren Resistlack der Fa. M und T Chemicals GmbH, Stuttgart, beschichtet. Nach 14 Tagen wird die aktive Halbzeugoberfläche mit einer Photomaske bedeckt und mit Hilfe von UV-Bestrahlung partiell vernetzt. Der nicht vernetzte Präpolymeranteil wird nach Entfernen der Maske vom Basismaterial in einer handelsüblichen Entwicklerlösung entfernt. Anschließend wird der Probekörper in einem Bad aus 1500 ml EtOH, 120 g $CaCl_2$, 20 ml p-Toluolsulfonamid und 3 g $AlCl_3$ bei Raumtemperatur 5 Minuten behandelt, gemäß Beispiel 1 sensibilisiert, mit einer handelsüblichen Siebdruckmaske, welche freie kammförmige Bahnen von etwa 150 µm Breite aufweist bedeckt, gewaschen und dann in einem handelsüblichen Verkupferungsbad auf dem chemischen Wege verkupfert.

Nach etwa einigen Minuten färben sich die freien Bahnen dunkel und nach ca. 30 Minuten wird eine elektrisch leitende Cu-Auflage abgeschieden.

Die Metallauflage haftet auf der Polymeroberfläche so gut, daß sie die Temperatur-Wechselprüfung nach DIN 53 436 besteht.

Beispiel 4

Eine 200 × 200 × 1 mm große handelsübliche Polytetrafluorethylen-Folie wird in einem Bad, welches aus 1 Mol Natrium, 1 Mol Naphthalin und 1 Liter THF (reinst.) besteht, 5 Minuten vorbehandelt. Anschließend wird die Platte mit Methanol neutral gewaschen und dann in einem Bad, welches aus 1,2 g n-3-Hepten-2-on-palladiumchlorid und 1000 ml $CCl_2=CHCl$ besteht, bei 30 °C 6 Minuten behandelt und anschließend getrocknet. Die so hergestellte aktive Platte wird gemäß Beispiel 1 mit einer Maske versehen, sensibilisiert und dann verkupfert. Die Metallauflage haftet auf der Polymeroberfläche so gut, daß sie trotz einer fünfminütigen Nachbehandlung bei 265 °C in einem handelsüblichen Lötbad nicht von der Polymeroberfläche zu entfernen ist.

Beispiel 5

Eine 200 × 200 × 1 mm große mit ca. 30 Gew.-% Mineralfasern verstärkte Polyvinylfluoridfolie wird in einem Bad, bestehend aus 90 g Lithiumbenzol und 900 ml THF (reinst) bei Raumtemperatur 5 Minuten behandelt, gemäß Beispiel 1 aktiviert, nach einer Lagerungszeit von einem Monat gemäß Beispiel 2 mit einer Resistmaske versehen, gemäß Beispiel 1 sensibilisiert und dann partiell gemäß Beispiel 2 vernickelt bzw. mit galvanischem Silber auf 40 µm verstärkt.

Man bekommt eine durchkontaktierte Leiterplatte mit 30 µm breiten und 40 µm starken Leiterbahnen. Die Abzugsfestigkeit der Metallauflage, gemessen nach DIN 53 494, beträgt ca. 50–60 N/25 mm und besteht den fünfminütigen Lötbadtest bei 250 °C.

Beispiel 6

Eine 200 × 300 mm Folie aus aromatischem Polyamid (Kondensationsprodukt aus Pyromellitsäuredianhydrid PMDA und 4,4'-Diaminodiphenylether) wird mit 0,25 mm großen Löchern versehen, gemäß Beispiel 3 aktiviert bzw. gelagert, gemäß Beispiel 3 mit einem UV-empfindlichen Lack der Fa. Merck AG beschichtet. Das so hergestellte aktive Halbzeug wird nach drei Tagen mit Hilfe von UV-Bestrahlung partiell vernetzt. Der nicht vernetzte Präpolymeranteil wird in einem handelsüblichen Entwicklerbad vom Probekörper entfernt. Anschließend wird der Probekörper gemäß Beispiel 1 sensibilisiert bzw. metallisiert.

Man bekommt eine metallisierte Leiterplatte. Die Metallauflage haftet an der Substratoberfläche so gut, daß sie trotz einer einminütigen Nachbehandlung bei erhöhter Temperatur (ca. 240 °C)

in einem handelsüblichen Lötbad nicht von der Polymeroberfläche zu entfernen ist.

Beispiel 7

Ein 100 × 200 mm großes Rechteck einer mit durchgehenden Löchern versehenen, handelsüblichen glasmattenverstärkten und chemisch aufgerauhten Epoxidharzplatte wird gemäß Beispiel 1 aktiviert. Nach einer Lagerungszeit von neun Tagen wird die Platte mit einer Siebdruckmaske in Form von 80 µm breiten und durchgehend kammförmigen Bahnen bedeckt, in einem Bad, welches aus 1000 ml Methanol, 40 ml Hydrazin und 12 ml $NH_3$-Lösung (25%ig) besteht, bei Raumtemperatur 5 Minuten sensibilisiert, gewaschen und dann gemäß Beispiel 2 vernickelt bzw. mit galvanischem Gold auf 40 µm verstärkt. Man bekommt eine durchkontaktierte Leiterplatte mit einer gut haftenden Metallauflage.

Beispiel 8

Ein 100 × 200 mm großes Rechteck einer mit durchgehenden Löchern versehenen, handelsüblichen Phenolharz-Hartpapier-Platte, deren Oberfläche eine 20 µm starke handelsübliche mit 30% Kautschuklatex versetzte Haftvermittlerauflage enthält, wird gemäß Beispiel 3 aktiviert, mit einem UV-Resistlack der Fa. Merck AG, Darmstadt, beschichtet. Nach 14 Tagen wird die aktive Platte gemäß Beispiel 3 entwickelt, gemäß Beispiel 7 sensibilisiert, gewaschen bzw. gemäß Beispiel 3 metallisiert.

Nach etwa einigen Minuten beginnt sich die Oberfläche dunkel zu färben und nach ca. 25 Minuten war eine metallisch glänzende gut haftende Metallschicht abgeschieden worden.

4-Cyclohexen-1.2-dicarbonsäureimid-palladium(II)-chlorid:

10 g 4-Cyclohexen-1.2-dicarbonsäureimid werden in der fünffachen Menge DMF (Dimethylformamid) gelöst, im Verlauf von 3 Stunden mit der äquimolaren Menge Acetonitrilpalladiumdichlorid bei 45 °C versetzt. DMF und Acetonitril werden bei 45 °C/25 mbar abdestilliert. Man erhält mit 95%iger Ausbeute einen gelb-bräunlichen Feststoff vom Schmelzpunkt ≈102 °C.

**Patentansprüche**

1. Verfahren zur Herstellung von Leiterplatten nach der Additiv- bzw. Semiadditivmethode durch partielle stromlose, naßchemische Metallisierung von Basisplatten mit Hilfe von metallorganischen Aktivatoren, wobei man

a) die Basisplatten mit einem Aktivatorsystem behandelt, das in einem Lösungsmittel Komplexverbindungen der Elemente der I. oder VIII. Nebengruppe des Periodensystems enthält, die mindestens eine haftvermittelnde funktionelle Gruppe aufweisen,

b) nach dem Verdampfen des Lösungsmittels eine Resistauflage aufbringt und diese nach einem Resistmuster partiell belichtet,

c) anschließend die unbelichteten und damit unvernetzten Bereiche der Resistauflage mit einem Lösungsmittel, das gleichzeitig ein Quellmittel für die Oberfläche der Basisplatten ist, herauslöst und

d) die auf diese Weise freigelegten Bereiche – gegebenenfalls nach Überführung in ein Sensibilisierungsbad – in einem üblichen naßchemischen Metallisierungsbad stromlos metallisiert und gegebenenfalls galvanisch verstärkt.

2. Verfahren nach Anspruch 1, dadurch gekennzeichnet, daß man als Komplexverbindungen π-Komplexe von Olefinen, konjugierten Dien und α,β-ungesättigten Ketonen sowie Chelatkomplexe von Nitril-, Amin-, Carboxyl-, Hydroxyl-, Sulfonsäure- und Sulfonamidgruppenhaltigen Verbindungen, die außer diesen zur Metallkomplexbildung benötigten Gruppen mindestens eine weitere funktionelle Gruppe enthalten, die die Haftfestigkeit des Aktivators auf der Substratoberfläche verbessert, verwendet.

3. Verfahren nach Anspruch 1 oder 2, dadurch gekennzeichnet, daß man als Komplexverbindungen solche verwendet, die als funktionelle Gruppen Carbonsäuregruppen, Carbonsäureanhydridgruppen, Amidgruppen, Carbonsäure-imidgruppen, Keto-, Aldehyd- und Estergruppen enthalten.

4. Verfahren nach Anspruch 1, dadurch gekennzeichnet, daß man als Komplexverbindungen Mesityloxid-palladiumchlorid, 3-Hepten-2-on-palladiumchlorid, Butadienpalladiumchlorid, 4-Cyclohexen-1,2-dicarbonsäureanhydridpalladium(II)-chlorid oder 4-Cyclohexen-1,2-dicarbonsäureimidpalladium(II)-chlorid verwendet.

5. Verfahren nach Anspruch 1, dadurch gekennzeichnet, daß man als Komplexverbindung 4-Cyclohexen-1,2-dicarbonsäureimid-palladiumchlorid verwendet.

6. Verfahren nach Anspruch 1, dadurch gekennzeichnet, daß man als Basisplatten solche aus gegebenenfalls glas- und/oder mineralfaserverstärkten und/oder kautschukgepfropften Polyamid-6, Polyamid-6.6, Polyamid-11 und Polyamid-12 bzw. deren Co- oder Mischkondensaten, oder Polytetrafluorethylen, Polyvinylfluorid und Polyvinylidenfluorid bzw. deren Mischungen untereinander oder verstärkten Epoxidharzen, Phenol-Formalinharzen und Melaminharzen bzw. deren Mischungen verwendet.

**Claims**

1. Process for the production of printed circuit boards by the additive or semi-additive method, by partial wet-chemical metallisation of baseplates in the absence of a current, with the aid of organometallic activators, in which

a) the baseplates are treated with an activator system containing in a solvent complex compounds of elements of sub-group I or VIII of the periodic table, which contain at least one adhesion-promoting functional group,

b) after the solvent has been vaporised, a resist layer is applied, and is partially exposed according to a resist pattern,

c) the covered, and therefore non-crosslinked, parts of the resist layer are then dissolved away with a solvent which may simultaneously be a swelling agent for the surface of the baseplates, and

d) the parts bared in this manner – if appropriate after transfer to a sensitisation bath – are metallised in a conventional wet-chemical metallisation bath in the absence of a current, and, if required, the thickness of the metallised parts is increased by electroplating.

2. Process according to Claim 1, characterised in that the complex compounds used are π-complexes of olefines, conjugated dienes and α,β-unsaturated ketones, and chelate complexes of compounds which contain nitrile, amino, carboxyl, hydroxyl, sulpho and sulphonamide groups and, in addition to the groups which are required for metal complex formation, contain at least one further functional group which improves the adhesion of the activator to the substrate surface.

3. Process according to Claim 1 or 2, characterised in that the complex compounds used are those which contain, as functional groups, carboxylic acid groups, carboxylic anhydride groups, amide groups, carboxylic acid imide groups, keto groups, aldehyde groups and ester groups.

4. Process according to Claim 1, characterised in that the complex compounds used are mesityl oxide-palladium chloride, hept-3-en-2-one-palladium chloride, butadiene-palladium chloride, 4-cyclohexene-1,2-dicarboxylic acid anhydride-palladium(II) chloride and 4-cyclohexene-1,2-dicarboxylic acid imide-palladium(II) chloride.

5. Process according to Claim 1, characterised in that the complex compound used is 4-cyclohexene-1,2-dicarboxylic acid imide-palladium chloride.

6. Process according to Claim 1, characterised in that the baseplates used are those which consist of optionally glass fibre-reinforced and/or mineral fibre-reinforced and/or rubber-grated nylon 6, nylon 6.6, nylon 11 or nylon 12 or their cocondensates or mixed condensates, or polytetrafluoroethylene, polyvinyl fluoride or polyvinylidene fluoride or their mixtures with one another or reinforced epoxy resins, phenol/formalin resins or melamine resins or their mixtures.

**Revendications**

1. Procédé pour la fabrication de plaques à circuit suivant la méthode additive ou semi-additive, par métallisation partielle sans courant par voie chimique humide des plaquettes de base à l'aide d'activateurs organiques métalliques comportant les phases suivantes:

a) traitement des plaquettes de base par un système d'activateur contenant, dans un solvant, des composés complexes des éléments du sous-groupe I ou VIII du système périodique et qui contiennent au moins un groupe fonctionnel conférant l'adhérence,

b) après évaporation du solvant, application d'un revêtement de résine photosensible et exposition partielle de ce revêtement à la lumière suivant un patron,

c) ensuite, dissolution des zones du revêtement de résine photosensible, non exposées et donc non réticulées, par un solvant qui est simultanément un agent gonflant pour la surface des plaquettes de base, et

d) éventuellement après transfert dans un bain de sensibilisation, métallisation sans courant dans un bain de métallisation ordinaire par voie chimique humide des zones dégagées de cette manière, et, éventuellement, leur renforcement par électro-déposition.

2. Procédé selon la revendication 1, caractérisé en ce que l'on utilise comme composés complexes des complexes π des oléfines, des diènes conjugués et des cétones α,β insaturées, ainsi que des complexes chélates de composés contenant les groupes nitrile, amine, carboxyle, hydroxyle, acide sulfonique et sulfonamide qui contiennent, outre les groupes nécessaires pour la formation des complexes métalliques, au moins un autre groupe fonctionnel qui améliore l'adhérence de l'activateur sur la surface du substrat.

3. Procédé selon la revendication 1 ou 2, caractérisé en ce que l'on utilise comme composés complexes ceux qui contiennent comme groupes fonctionnels des groupes d'acide carboxylique, des groupes d'anhydride carboxylique, des groupes d'amide, des groupes d'imide carboxylique, des groupes cétone, aldéhyde et ester.

4. Procédé selon la revendication 1, caractérisé en ce que l'on utilise comme composés complexes l'oxyde de mésityle – chlorure de palladium, le 3-heptène-2-one-chlorure de palladium, le butadiène-chlorure de palladium, l'anhydride de l'acide 4-cyclohexène-1,2-dicarboxylique – chlorure de palladium bivalent ou l'imide de l'acide 4-cyclohexène-1,2-dicarboxylique – chlorure de palladium bivalent.

5. Procédé selon la revendication 1, caractérisé en ce que l'on utilise comme composé complexe l'imide de l'acide 4-cyclohexène-1,2 dicarboxylique – chlorure de palladium.

6. Procédé selon la revendication 1, caractérisé en ce que l'on utilise comme plaquettes de base celles qui sont à base de polyamide 6, de polyamide 6.6, de polyamide 11 et de polyamide 12 ou de leurs produits de co-condensation ou de condensation mixte, renforcés éventuellement par des fibres de verre et/ou minérales et/ou greffés au caoutchouc, ou le polytétrafluoréthylène, le chlorure de polyvinyle et le fluorure de polyvinylidène ou leurs mélanges entre eux ou bien des résines mélamine, des résines phénol-formaldéhyde et des résines époxy renforcées ou leurs mélanges.